# EUROPEAN PATENT APPLICATION

(11) **EP 1 498 948 A2**
(43) Date of publication of application: **19.01.2005**
(21) Application number: 04016793.4
(22) Date of filing: 16.07.2004
(51) Int. Cl.: H01L 23/498, H01L 23/48

(54) **A reconnectable chip interface and chip package**

(30) Priority: 17.07.2003 US 621773
(71) Applicant: Cookson Electronics, Inc., Providence, Rhode Island 02909 (US)
(72) Inventor: Gilleo, Kenneth B., Warwick, Rhode Island 02889 (US)
(74) Representative: Stenger, Watzke & Ring Patentanwälte

(57) **Abstract**

An assembly of the present invention has a substrate and an integrated circuit device adapted to be electrically and mechanically connected to the substrate. Electrical connection pads on the circuit device and on the substrate contact one another when the circuit device and the substrate are connected. At least one first projection on one of the device and on the substrate and at least two second projections on the other of the device and the substrate each have a respective axial length and are sized and shaped for a close friction fit along their axial lengths when the projections are interdigitated relative to one another. An integrated circuit device package of the present invention includes an integrated circuit device and an interconnect substrate for mounting the circuit device on an electronic circuit substrate. The interconnect substrate mates with the active side of the circuit device to form an enclosed space.

## Description

### Background of the Invention

The present invention relates generally to an integrated circuit assembly, and more particularly to an electro-mechanical connection between a microchip and a substrate. This invention also relates to an integrated circuit device package for protecting an integrated circuit device and a process for forming such a package.

Integrated circuit devices (i.e., microchips, chips, or dies) are typically connected to a substrate (e.g., chip carrier, package, or circuit board) using well-know methods such as Direct Chip Attach (DCA) and wire bonding. DCA uses joining materials such as metallurgical solders or polymeric conductive adhesives that are typically applied to the electrical connection pads (i.e, bond pads) of the chip. The chip can then be electromechanically connected to corresponding bond pads on a substrate by applying heat to melt, or reflow the solder. A protective polymer, called underfill, is applied to the gap between the chip and substrate and then hardened by heating to cause the liquid to polymerize to a solid and provide further bonding between the chip and substrate. In wire bonding, an adhesive or solder is used to attach the chip to the substrate. After chip attachment, fine metal wires are then welded to each chip electrical connection pad and to the corresponding substrate electrical connection pad by using heat or ultrasonic energy. Reference may be made to U.S. Patent Nos. 5,439,162 and 5,665,654, both of which are incorporated by reference herein for all purposes, for additional background information relating to DCA and wire bonding chip attachment processes. While DCA and wire bonding processes typically result in a reliable chip connection, the connection is considered permanent and does not allow removal and reconnection of the chip. Also, the heat required to reflow the solder or adhesive frequently damages the microchip and decreases production efficiencies.

Existing electro-mechanical chip connection methods that eliminate thermal bonding processes allow a conventional microchip device to be electrically and mechanically mounted on a substrate of the circuit so that the chip can be removed and reconnected without heating the chip or the substrate. These conventional electro-mechanical connection methods typically include metallized interlocking structures (i.e., hook and loop configurations, locking inserts and sockets, interlocking micromechanical barbs) located on the electrical connection pads of the microchip and the substrate. Reference may be made to U.S. Patent Nos. 5,411,400, 5,774,341, and 5,903,059, which are incorporated by reference herein for all purposes, for additional background information relating to existing reconnectable electro-mechanical connections between an electronic device and a substrate. Existing reconnectable chip interface structures have not seen widespread acceptance in the industry because of high manufacturing costs and low reliability of operation.

MEMS, or Micro-Electro-Mechanical Systems, are integrated circuit devices that often have moving parts, or microstructures that can cause materials to move (as with thermal ink jet printer chips). A general requirement for packaging MEMS devices is that no encapsulant or enclosure can make contact with the active surface, or face, of the chip. Even integrated circuit devices without moving parts, such as radio frequency components including inductor coils, are better served by packages with a free space since encapsulants can "detune" a high-frequency device. DCA cannot be used to directly connect the MEMS device to an electronic substrate because the underfill that is applied to the area between the chip and the substrate, would cover the active surface. Unfortunately, the conventional low cost packaging method, transfer molding, applies plastic encapsulant over the chip thus rendering most MEMS devices useless. The same is true of liquid encapsulants applied by needle dispensing. No effective, low cost packaging method for MEMS devices now exists.

The most common package for a MEMS device or other integrated circuit device is a metal or ceramic hermetic enclosure that can be conceptually regarded as a tiny box with a lid applied after the chip is inserted and connected. Insulated electrical leads must pass through to the outside of the box thus adding cost and limiting the number of connections. These existing hermetic enclosures are made of metal or ceramic and cost approximately 10 to 100 times more than transfer molded plastic packages. The hermetic lid must be welded, soldered or brazed and this can heat the devices within the enclosure that are usually heat-sensitive. Typical metal or ceramic hermetic enclosures are generally much larger than the size of the chip and require much more circuit board mounting space than if the chip were directly mounted to the board.

Alternative chip packaging designs, referred to as chip-scale packages (CSP), reduce the size of the package to take up less circuit board space. Existing CSP designs have a cap attached to a base substrate on which the integrated circuit device is mounted. A gasket or adhesive layer around the periphery of the electrical connection pads on the base wafer bonds and seals the cap to the wafer to provide an enclosure that is significantly larger than the active side of the integrated circuit device. Reference may be made to U.S. Patent Nos. 6,228,675 and 6,441,481, which are incorporated by reference herein for all purposes, for additional background information relating to existing CSP designs. Existing CSP designs lack an interconnect for direct electrical connection to the circuit board. As a result, the capped microchip must go through interconnect processing (e.g., wire bonding) after the cap and the base substrate have been bonded. A chip-scale package (CSP) is generally defined as a chip package in which the total package size is no more than approximately 20% greater than the size of the circuit device enclosed within the package. As technology is driven toward a higher degree of miniaturization, CSP designs that are sized at or near the 20% guideline have become inadequate in meeting the miniaturization needs of the electronics industry. Therefore, there is a need for a simple microchip package that is more economical and reliable than existing ceramic packages and for a microchip package that is easier to manufacture and smaller than existing package designs.

### Summary of the Invention

Among the several objects of this invention may be noted the provision of an assembly which allows an electro-mechanical connection of a integrated circuit device to a substrate at ambient temperatures; the provision of such an assembly which allows economical manufacture; the provisions of such an assembly which permits simple testing; the provision of such an assembly which allows easy rework; and the provision of such an assembly that allows easy removal and replacement of the integrated circuit device.

Further among the several objects of this invention may be noted the provision of a package for protecting an integrated circuit device which is easy to manufacture; the provision of such a package which is small in scale; the provision of such a package which allows reliable electrical and mechanical connection to a substrate; the provision of such a package which provides sufficient protective space for the circuit device; the provision of a package which reduces fabrication steps; and the provision of such a package which allows reconnectable electrical connection with an electronic circuit substrate.

In general, an assembly of the present invention comprises a substrate and an integrated circuit device adapted to be electrically and mechanically connected to the substrate. A first set of electrical connection pads on the circuit device and on the substrate are adapted to contact one another when the circuit device and the substrate are connected. The set of connection pads comprises at least one first projection on one of the device and on the substrate and at least two second projections on the other of the device and the substrate. Each projection has a respective axial length extending from an external surface of a respective connection pad. The first projection and the second projection are sized and shaped for a close friction fit along their axial lengths when the projections are interdigitated relative to one another thereby to establish an electrical and mechanical connection between the device and the substrate.

In another aspect of the invention, the assembly comprises a substrate having a plurality of connection pads. Each pad comprises a plurality of spaced apart electrically conductive projections extending from an external surface of the pad and forming an open space therebetween. An integrated circuit device is adapted to be electrically and mechanically connected to the substrate. The device has a plurality of connection pads with each pad comprising at least one electrically conductive projection extending from an external surface of the pad. The electrically conductive projection on the device is adapted for insertion into the open space such that the device and the substrate are held in electrical and mechanical connection by a friction fit between respective projections.

In another aspect of the present invention, the assembly comprises a substrate and
an electrical circuit device adapted to be electrically and mechanically connected to the substrate. A first connection pad on the substrate comprises a first set of two or more electrically conductive connecting elements protruding from an external surface of one pad. Each connecting element of the first set has an axial length generally perpendicular to the substrate. A second connection pad on the circuit device comprises a second set of one or more electrically conductive connecting elements protruding from an external surface of the pad. Each connecting element of the second set has an axial length and is adapted for interdigitation with the connecting elements of the first set of connecting elements. The first and second sets of connecting elements are sized and shaped for a close friction fit along their axial lengths when interdigitated relative to one another thereby to establish an electrical and mechanical connection between the device and the substrate.

In general, an integrated circuit device package of the present invention comprises an integrated circuit device having an active side with at least one electrical connection pad thereon and an interconnect substrate for mounting the integrated circuit device on an electronic circuit substrate. The interconnect substrate has a first side adapted to mate with the active side of the integrated circuit device to form an enclosed space and a second side adapted for electrical and mechanical connection to the electronic circuit substrate. The interconnect substrate has at least one set of electrical connection pads with each set comprising a first electrical connection pad on the first side of the interconnect substrate adapted for electrical connection to the at least one electrical connection pad on the integrated circuit device and a second electrical connection pad on the second side of the interconnect substrate electrically connected to the first connection pad. The second electrical connection pad on the second side of the interconnect substrate is adapted for electrical and mechanical connection to the electrical circuit substrate.

In another aspect of the invention, an integrated circuit device package comprises
an integrated circuit device having an active side with at least one electrical connection pad thereon. An interconnect substrate for mounting the integrated circuit device on an electronic circuit substrate has a first side adapted to mate with the active side of the integrated circuit device to form an enclosed space and a second side adapted for electrical and mechanical connection to the electronic circuit substrate. The interconnect substrate has at least one set of electrical connection pads, each set comprising a first electrical connection pad on the first side of the interconnect substrate adapted for electrical connection to the at least one electrical connection pad on the integrated circuit device and a second electrical connection pad on the second side of the interconnect substrate electrically connected to the first connection pad. The second electrical connection pad on the second side of the interconnect substrate is adapted for electrical and mechanical connection to the electrical circuit substrate.

Another aspect of the invention is directed to a process for forming an integrated circuit device scale package. The process comprises the steps of fabricating an integrated circuit device wafer having an active side, and fabricating an interconnect substrate such that the wafer has electrical connection pads on opposite sides thereof and a recessed surface. The integrated circuit device wafer and interconnect substrate wafer are electrically and mechanically connected such that the two wafers form an enclosed space between the active side of the integrated circuit device wafer and the recessed surface of the interconnect substrate wafer. The integrated circuit device wafer and interconnect substrate wafer are diced to form an individual integrated circuit device package.

In yet another aspect of the invention an interconnect substrate for mounting an integrated circuit device on an electronic circuit substrate comprises a first side adapted to mate with an active side of the integrated circuit device to form an enclosed space and a second side adapted for electrical and mechanical connection to the electronic substrate. A first electrical connection pad on the first side of the interconnect substrate is adapted for electrical connection to the integrated circuit device. A second electrical connection pad on the second side of the interconnect substrate is electrically connected to the first connection pad. The second electrical connection pad on the second side of the interconnect substrate is adapted for electrical and mechanical connection to the electronic circuit substrate.

Other objects and features will be in part apparent and in part pointed out hereinafter.

### Brief Description of the Drawings

Fig. 1 is an elevation, partially in section, of a chip module showing an assembly of the present invention;
Fig. 2 is an exploded perspective of an integrated circuit device and a substrate of the module;
Fig. 3 is an enlarged perspective of an integrated circuit device electrical connection pad and a substrate electrical connection pad of a first embodiment of the assembly;
Fig. 4 is a cross-section in the plane including line 4-4 of Fig. 3;
Fig. 5 is a cross-section in the plane including the line 5--5 of Fig. 4;
Fig. 6 is a cross-section similar to Fig. 5 but showing the circuit device electrical connection pad and substrate electrical connection pad fully interdigitated;
Fig. 7 is an enlarged side elevation of the integrated circuit device and substrate of the first embodiment;
Fig. 8 is an enlarged perspective of an integrated circuit device electrical connection pad of a second embodiment of the present invention;
Fig. 9 is a cross-section similar to Fig. 4 but showing a third embodiment of the present invention;
Fig. 10 is an enlarged perspective of an integrated circuit device electrical connection pad and a substrate electrical connection pad of a fourth embodiment of the present invention;
Fig. 11 is a cross-section in the plane including line 11-11 of Fig. 7;
Fig. 12 is an elevation of a integrated circuit device package of the present invention attached to a electronic circuit substrate;
Fig. 13 is an cross-section of the package of Fig. 12 removed from the electronic circuit substrate;
Fig. 14 is an exploded elevation of the package removed from the electronic circuit substrate;
Fig. 15 is an enlarged fragmentary view of an integrated circuit device and an interconnect substrate, partially in section, of a first embodiment of the package;
Fig. 16 is an enlarged fragmentary view of an integrated circuit device and an interconnect substrate, partially in section, of a second embodiment of the package;
Fig. 17 is an enlarged fragmentary view of an integrated circuit device and an interconnect substrate, partially in section, of a third embodiment of the package;
Fig. 18 is a cross-section similar to Fig. 13 but showing a fourth embodiment of the package;
Fig. 19 is a perspective of an integrated circuit device wafer and a interconnect substrate wafer as used in a process for forming an integrated circuit device package of the present invention;
Fig. 19A is an enlarged side elevation of the integrated circuit device wafer;
Fig. 19B is an enlarged side elevation of the interconnect substrate wafer;
Fig. 20 is a perspective of an integrated circuit device wafer and interconnect substrate wafer connected in accordance with a process of this invention; and
Fig. 21 is a perspective of integrated circuit device packages fabricated according to the process.

Corresponding parts are designated by corresponding reference numbers throughout the drawings.

### Detailed Description of Preferred Embodiments

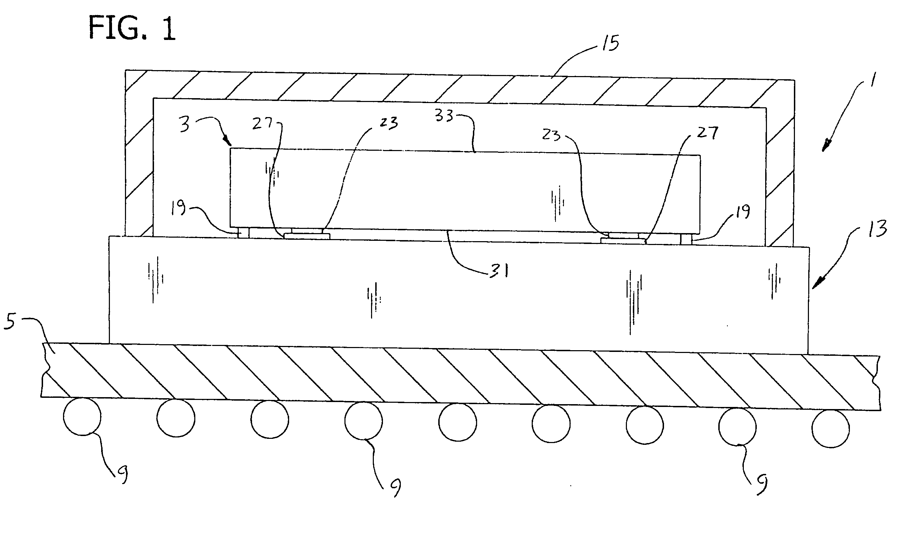

Referring now to the drawings, and more particularly to Fig. 1, a chip module, generally designated 1, comprises an integrated circuit device, generally designated 3, assembled in accordance with the present invention. In the particular embodiment of Fig. 1, the module 1 is affixed to a conventional ball grid array 5 having solder balls 9 for electrical connection to a printed circuit board (not shown). It will be understood that the chip module 1 could be directly attached to the circuit board or could be attached via other conventional connecting substrates (e.g., a pin-grid array or a land grid array). Also, the module 1 could include more than one integrated circuit device 3 assembled in accordance with the present invention.

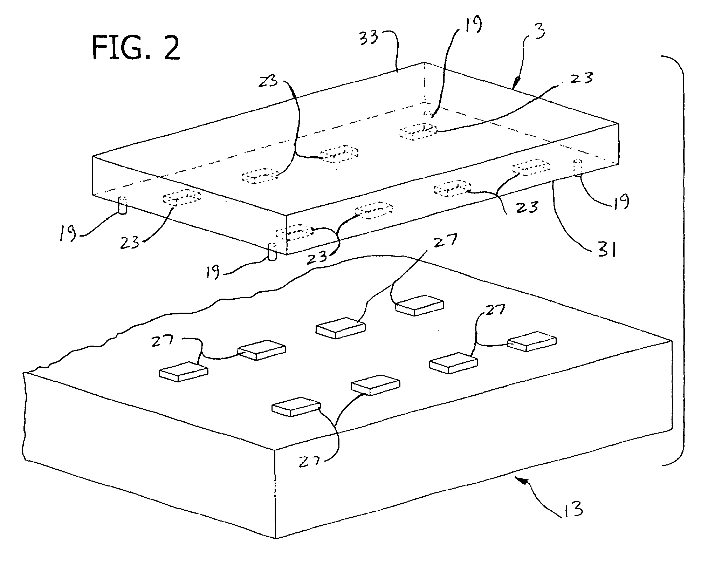

As shown in Figs. 1 and 2, the integrated circuit device 3 of the module 1 is electrically and mechanically attached to a chip carrier substrate generally designated 13. In the illustrated embodiments, the circuit device 3 is shown schematically but it will be understood that each device could comprise any typical integrated circuit device such as a Micro-Electronic Mechanical Systems (MEMS) device, Optoelectronic (OE) device or any other microchip that may be used in an electronic circuit. The module 1 shown in Fig. 1 includes a protective cap 15 made from conventional materials (i.e., metal, ceramic, or plastic) that is affixed to the chip carrier substrate 13 by conventional means (i.e., welding, soldering, brazing) to enclose and protect the integrated circuit device 3. Alternatively, the cap 15 of the module 1 could have an access window (not shown) to allow light to pass through the cap, or the module could be supplied without a cap.

A seen in Figs. 1 and 2, the integrated circuit device 3 has four stops 19 integral with the device that project from the bottom surface of the device to contact the substrate 13. In one embodiment each stop 19 is a solid cylindrical body fabricated as part of the chip fabrication process from the same semiconductor material as the circuit device 3 and located near a respective comer of the circuit device. As will be discussed below in more detail, the stops 19 limit the spacing of the chip 3 relative to the substrate 13 and also assure that the chip and substrate are aligned in parallel planes.

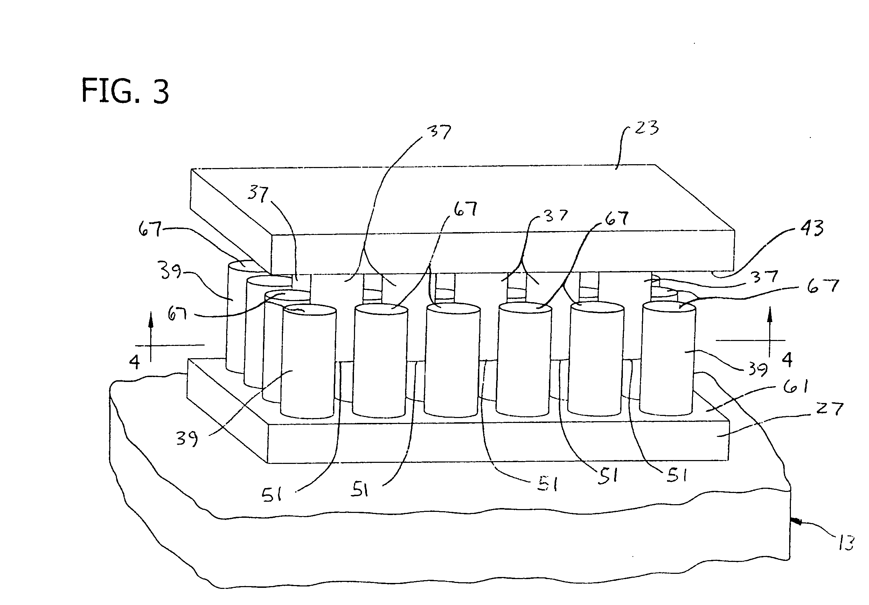

In the embodiment of Fig. 2, the module 1 has eight sets of electrical connection pads (i.e., bond pads) 23 on the integrated circuit device 3 for mating with corresponding electrical connection pads 27 and on the substrate 13. Each connection pad 23 on the circuit device 3 is a metal pad fabricated on the surface of the device and arranged to contact a corresponding pad 27 on an opposing surface of the chip carrier substrate 13. Each electrical connection pad 23, 27 is electrically connected via conventional means to the circuitry of the microchip 3, or the substrate 13, so that electrical signals can be received and transmitted through the pads. In the illustrated embodiment the connection pads 23 are located near the periphery of the bottom (passive) side 31 of the device 3 but it will be understood that the pads could be located on the top (active) side 33 of the chip. Also, more or less than eight pads 23, 27 could be provided without departing from the scope of this invention. It will be understood that the total number of connection pads 23, 27 on the chip 3 and the substrate 13 will vary depending on the specific technology and application of the integrated circuit device and that hundreds or thousands of external connection terminals may exist on the microchip and the substrate. Each connection pad 23 is located for attachment to a corresponding (mating) connection pad 27 on the substrate 13 so that an electrically conductive path is provided between the integrated circuit device and the substrate. As will be discussed below in more detail, each pair of mating connection pads 23, 27 on the chip 3 and the substrate 13 includes cooperating connecting elements 37, 39 (Fig. 3) that are capable of electrically and mechanically connecting the integrated circuit device to the chip carrier substrate.

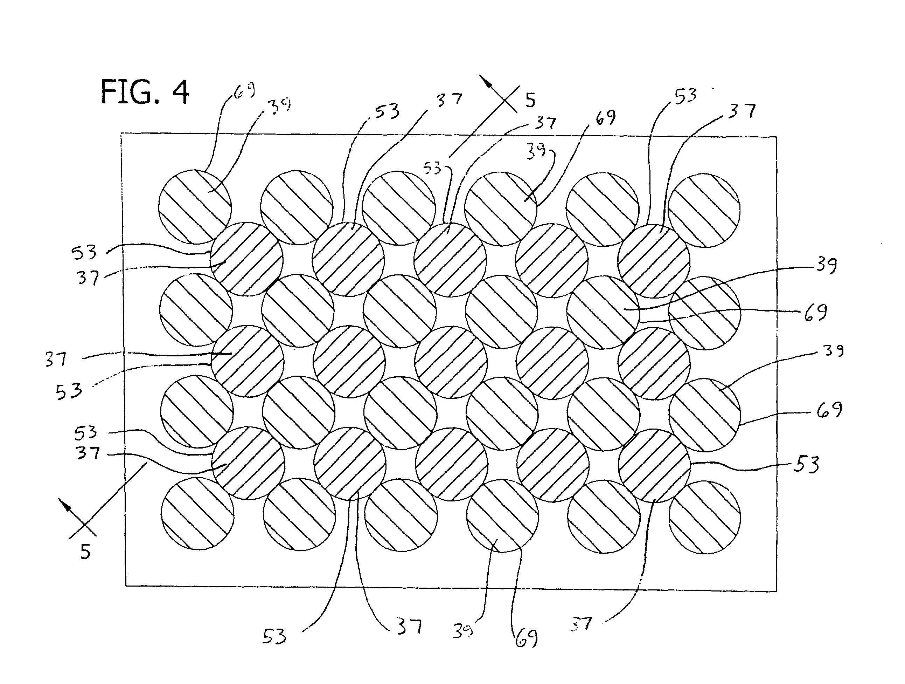

As shown in Fig. 3, each electrical connection pad 23 on the integrated circuit device 3 has an external surface 43 generally parallel with the device and comprises at least one, and probably more than one, electrically conductive connecting element 37, each of which comprises a first projection protruding from the flat external surface of the pad. In the embodiment of Figs. 3 and 4, each first projection 37 comprises a solid cylindrical body having a flat, circular free end 51 and an external surface 53 with an axial length generally perpendicular to the flat external surface 43 of the connection pad 23. It will be understood that the projections 37 may have other shapes and configurations without departing from the scope of this invention. In one embodiment, each projection 37 is fabricated as an integral part of the connection pad 23 and comprises any suitable metal or metal alloy (e.g., copper or copper alloys). Preferably, each connecting element 37 comprises a projection made from the same semi-conductor material as the microchip device 3 (e.g., silicon, ceramic, or any other suitable semi-conductor material) by using conventional fabrication processes such as microelectronic photolithographic techniques (i.e., LIGA processes or surface micromachining and etching) prior to metallizing the connection pad 23. After fabrication of the microchip device 3, the projections 37 and surrounding area on the bottom side 31 of the device are metallized by conventional processes such as vacuum metal deposition, electroless plating, or electrolytic plating to form the electrically conductive chip connection pad 23 that comprises the metallized projections and the flat external surface 43 surrounding the projections. Alternatively, each projection 37 may be made of solid metal fabricated from conventional microfabrication processes such as electroplating, sputtering, or LIGA that are well suited for making three-dimensional metal projections bonded to the flat surface 43 of the integrated circuit device connection pad 23. This alternative method of fabrication results in metal projections 37 bonded to the connection pad 23 after the conventional chip fabrication steps have been completed.

Referring again to Fig. 3, each electrical connection pad 27 on the substrate 13 comprises a plurality of spaced apart electrically conductive connecting elements 39, each of which comprises a second projection extending from a flat external surface 61 of the pad that is substantially parallel with the substrate. As seen in Figs. 3 and 4, each second projection 39 comprises a solid cylindrical body having a flat, circular free end 67 and an external surface 69 with an axial length generally perpendicular to the flat external surface 61 of the connection pad 27. Preferably, each second projection 39 is constructed similar to the first projections 37 on the circuit device 3 and may be made from conventional semiconductor material that is metallized to have an electrically conductive external surface 69. It will be understood that the projections 39 on the substrate connection pads 27 may be fabricated from the same materials using the same manufacturing processes as described above for the first projections 37 on the integrated circuit device 3. Also, the second projections 39 may have other shapes and configurations without departing from the scope of this invention.

As seen in Figs. 3-6, the first projections 37 on the integrated circuit device 3 and second projections 39 on the substrate 13 are adapted for interdigitation to form an electrical and mechanical connection between the device and the substrate. More specifically, the first and second projections 37, 39 are sized and shaped for a close friction fit with one another along their respective axial lengths when the circuit device 3 is mounted to the substrate 13. In one embodiment, a grouping of four second projections 39 is spaced apart to form an open space to receive a first projection 37 such that the external axial surface 53 of the first projection contacts the external axial surface 61 of each of the four second projections. Alternatively, the second projections 39 could be otherwise located such that more or less than four projections contact the external surface 53 of each first projection 37. The contact of the external axial surface 53 of each first projection 37 and the external axial surface 69 of each surrounding second projection 39 creates a friction fit providing a mechanical connection force that resists separation of the device 3 and the substrate 13. It will be understood that the device and the substrate, 3 and 13 respectively, may also be held in contact by surface attractive forces (e.g., stiction forces) that are common in microchip connections. Also, if the projections 37, 39 are made from metallized semiconductor material, the projections may resiliently deform upon interdigitation, with each projection being capable of flexing from a position perpendicular to the device 3 or substrate 13 by several degrees of arc to facilitate insertion of the projections. The friction, surface attraction, and/or mechanical forces created by the interdigitation of the first and the second projections 37, 39 provide a connection force which is sufficient to hold the integrated circuit device 3 in a fixed position relative to the substrate 13 without the need for the application of adhesives or solders to the connection pads 23, 27. However, the connection force holding the integrated circuit device 3 and substrate 13 in electro-mechanical connection is small enough so that the device may be removed, replaced and repositioned on the substrate without the need for extensive rework of the connection pads 23, 27. The device 3 may be mounted on the substrate 13 by interdigitation of the first and second projections 37, 39 during final component assembly or during testing of the integrated circuit device.

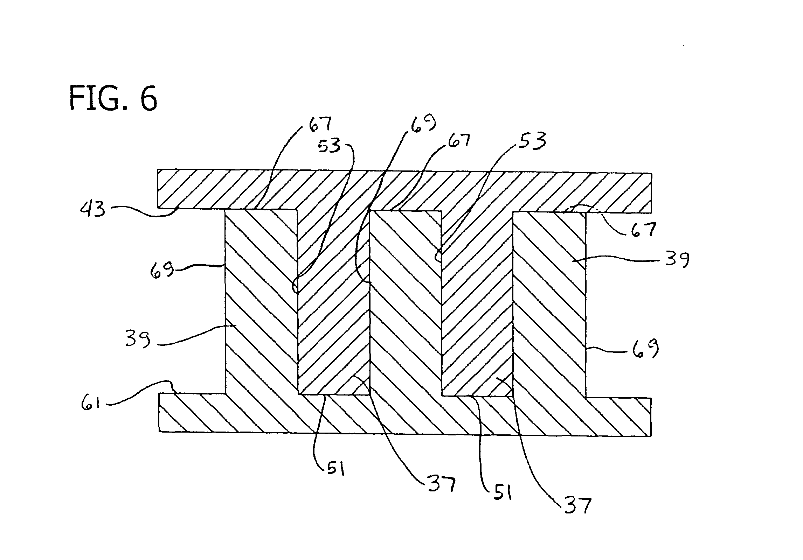

As shown in Fig. 6, the integrated circuit device 3 may be attached to the substrate 13 such that the first projections 37 on the device and the second projections 39 on the substrate are fully interdigitated (i.e., at least one of the free ends 51, 67 of respective projections contacts the flat surface 43, 61 of respective connection pads 23, 27). Full insertion of each first projection 37 into the open space between respective adjacent second projections 39 provides an increased contact area between the projections and the highest amount of mechanical connection force holding the chip 3 on the substrate 13.

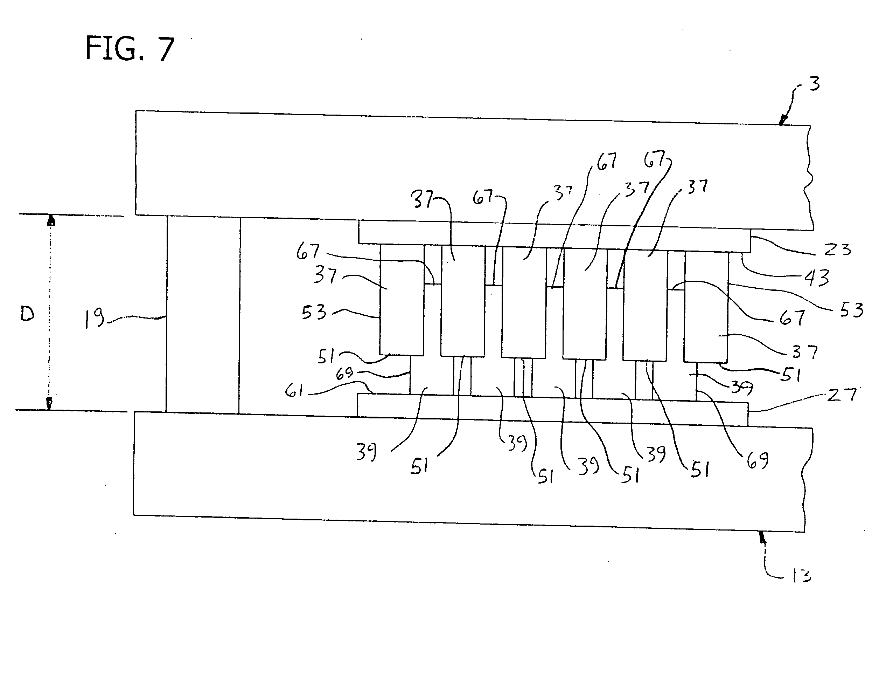

Alternatively, the device 3 may be an optoelectronic or optical-MEMS device that requires vertical alignment for the transfer of light between adjacent devices. As shown in Figs. 2 and 7, the stops 19 may be located at the four comers of the circuit device 3 to contact the substrate 13 so that the integrated circuit device is held at a desired distance D apart from the substrate. The stops 19 that extend from the circuit device near a respective comer of the device contact the substrate 13 so that the device and the substrate are parallel relative to one another upon interdigitation of the projections 37, 39. Adjacent circuit devices (not shown) may be configured with identical stops 19 to align the circuit devices at the same height so that optical signals (i.e., light) may be transferred between the devices. Also, the stops 19 reduce the amount of overlap between projections, reducing the amount of respective axial length of each projection is in electrical and mechanical contact. The amount of overlapping axial length of respective projections that is required for a particular integrated circuit varies depending on the size and electrical circuit requirements of the integrated circuit device. Typically, the amount of overlap can be in the range of 25% to 100% of the axial length of the projections.

In one exemplary embodiment, each bond pad 23 on the device 3 and each pad 27 on the substrate 13 may have a length of about 100 microns and a width of about 100 microns. Each first projection 37 and second projection 39 may have a minimum length of approximately 12 microns and a minimum diameter of approximately 1 micron. Each stop 19 may have a length of approximately 16 microns with a corresponding distance D (Fig. 7) between the device 3 and the substrate 13 of approximately 16 microns and a corresponding overlap of the axial lengths of interdigitated projections 37, 39 being approximately about 8 microns (66% of the total axial length of a respective projection). The minimum spacing between projections 37, 39 would be approximately 1 micron, making the maximum number of projections in one embodiment approximately 250 with projections arranged in 50 rows and 50 columns. More preferably, a fewer number of projections 37, 39 could be used with each projection having a larger diameter. In one embodiment, a single first projection 37 could be provided on the microchip device 3 having a diameter of approximately 100 microns and a length of approximately 12 microns and three second projections 39 could be provided on the substrate 13 with each projection having a diameter of approximately 30 microns and a length of approximately 12 microns.

It will be understood that the first and second projections 37, 39 described above can have other dimensions and can be otherwise arranged without departing from the scope of this invention. The amount of contact surface area between the first and second projections is directly proportional to the electrical conductivity between the projections and is also directly proportional to the mechanical connection force holding the integrated circuit device 3 and the substrate 13 together. The number of projections 37, 39, the dimensional configuration of the projections, and the amount of overlap of the axial length of the projections will vary based on the specific application and the amount of electrical conductivity and mechanical connection force required. For example, high current applications may require a larger number of interdigitated projections 37, 39 so that a higher amount of current can be transferred between the circuit device 3 and ths substrate 13.

In operation, an integrated circuit assembly 1 of the present invention is created by electrically and mechanically connecting the integrated circuit device 3 to the chip carrier substrate 13. The circuit device 3 is mechanically and electrically connected to the substrate 13 by the interdigitation of at least one first projection 37 on the circuit device with at least two second projections 39 on the mating substrate. The friction fit between the first projections 37 and second projections 39 creates a secure electrical and mechanical connection between the integrated circuit device 3 and the substrate 13. The chip carrier substrate 13 receives electrical signals from a printed circuit board (not shown), or other components of an electronic circuit, that are transferred to the integrated circuit device 3 through the contact of the electrically conductive first projections 37 with the electrically conductive second projections 39. Alternatively, the assembly 1 maybe configured with the first projection 37 on the substrate 13 and the second projections 39 on the integrated circuit device 3 so that the electrical and mechanical connection between the device and the substrate is established through the interdigitation of the projections.

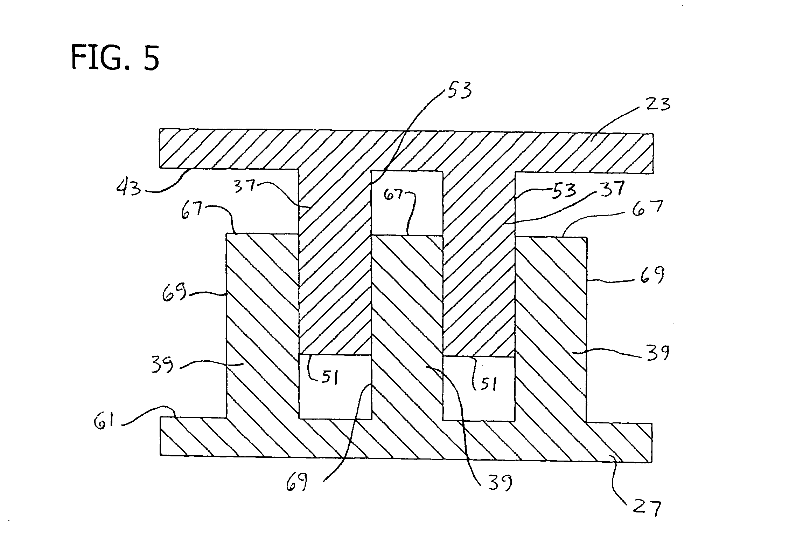

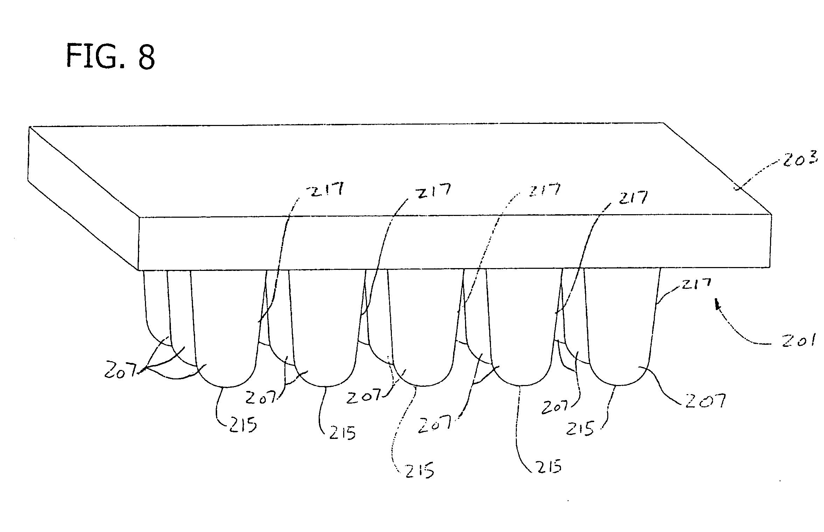

Fig. 8 illustrates a second embodiment of the present invention, generally designated 201, comprising an integrated circuit device connection pad 203. The connection pad 203 of this embodiment is substantially similar to the connection pad 23 of the first embodiment except the pad of this embodiment includes first projections 207. Each first projection 207 of the integrated circuit device connection pad 203 has a solid frustrum-shaped body of circular cross section with a rounded free end or tip 215 and a tapered exterior surface 217 that increases in diameter from the free end to the base of the projection. Each first projection 207 may be made from metal or other conductive materials as in the first embodiment and may be configured for interdigitation with cylindrical second projections 39 (Fig. 5) on the substrate 13. Alternatively, the first projections 207 may mate with second projections on the substrate that are similar in construction as the first projections or with second projections having other shapes and configurations without departing from the scope of this invention. It will be understood that the rounded tip 215 of each projection 207 allows quick and easy location (i.e., guiding) of the first projection between respective second projections 39 (Fig. 8) on the substrate 13. The tapered external surface 217 of each first projections 207 allows for a tighter friction fit with the second projections 39 and results in a mechanical holding force that increases upon further insertion of the device 3 toward the substrate 13. This embodiment 201 may be particularly useful in applications requiring a more durable and shock resistant electrical connection between the integrated circuit device 3 and the substrate 13.

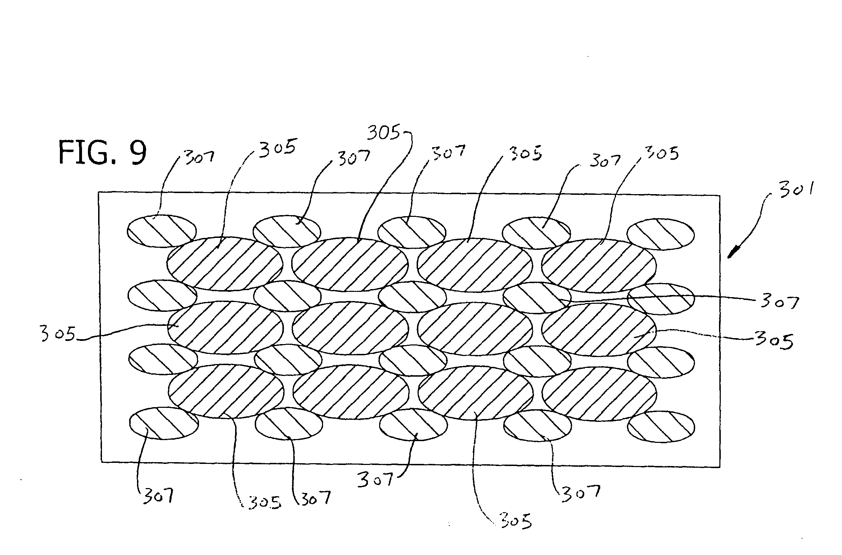

Fig. 9 illustrate a cross-section of a third embodiment of the present invention, generally designated 301. This embodiment 301 is substantially similar to the first embodiment but the first projections 305 on the circuit device and the second projections 307 on the substrate 13 have elliptical or oval cross-sections. In one embodiment, each elliptical first projection 305 is larger than the elliptical second projection 307 of this embodiment, but the first and second projections could have other sizes or could be otherwise arranged without departing from the scope of this invention. It will be understood that the first and second projections 305, 307 of this embodiment may be made from metal or other electrically conductive material by using the same processes as set forth above for the first embodiment.

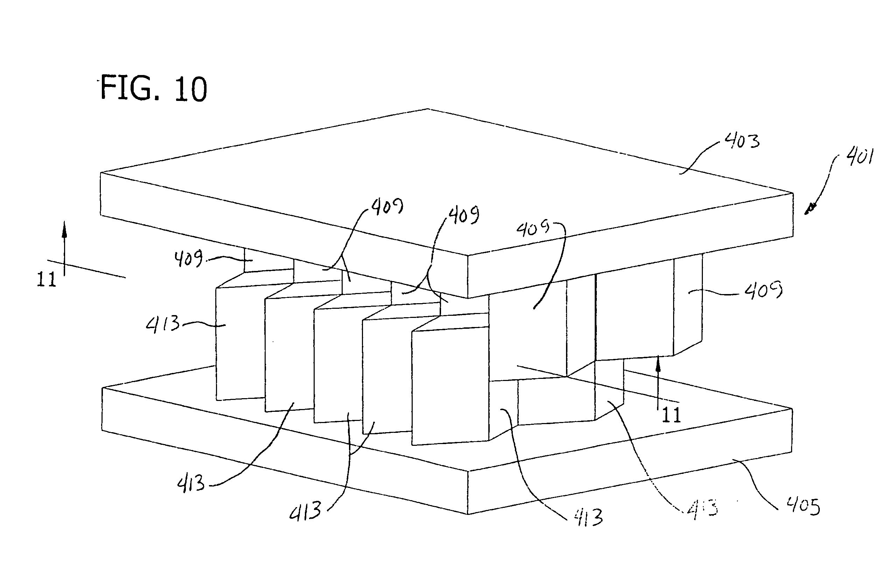

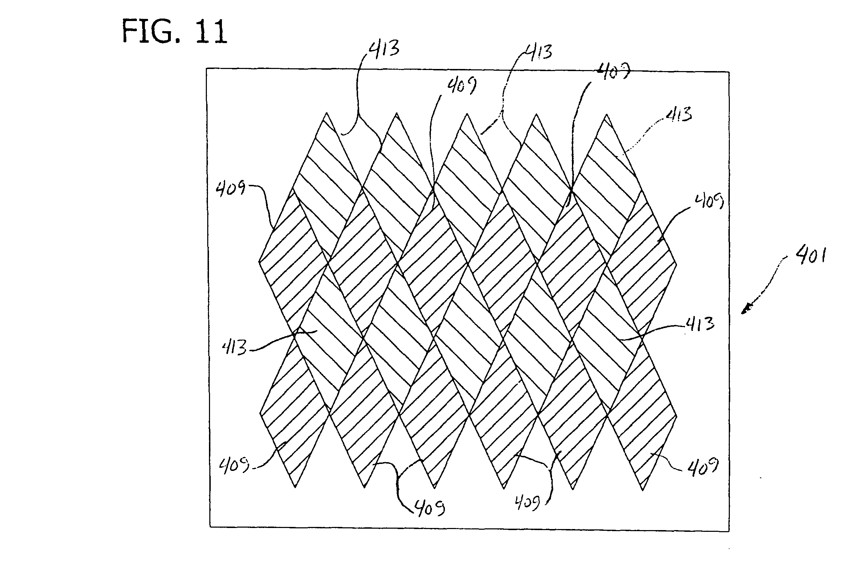

Figs. 10 and 11 illustrate a fourth embodiment of the present invention, generally designated 401, comprising connection pads 403 on the integrated circuit device 3 (Fig. 1) and connection pads 405 on the substrate 13 (Fig. 1) similar to the previous embodiments. Each connection pad 403 on the circuit device 3 has first projections 409, and each connection pad 405 on the substrate 13 has second projections 413. Each projection 409, 413 has a polygonal cross-section with generally flat contact surfaces. In the particular embodiments of Figs. 10 and 11, each first and second projection 409, 413 comprises a solid parallelogram-shaped body extending from a respective electrical connection pad 403, 405 . The interdigitation of the first and second projections 409, 413 of this embodiment provides a greater contact surface area between the projections to allow a greater current carrying capacity between the device 3 and the substrate 13. It will be understood that the first and second projections 409, 413 may have other polygonal cross-sections (e.g., rectangular, square, triangular, etc.) without departing from the scope of this invention.

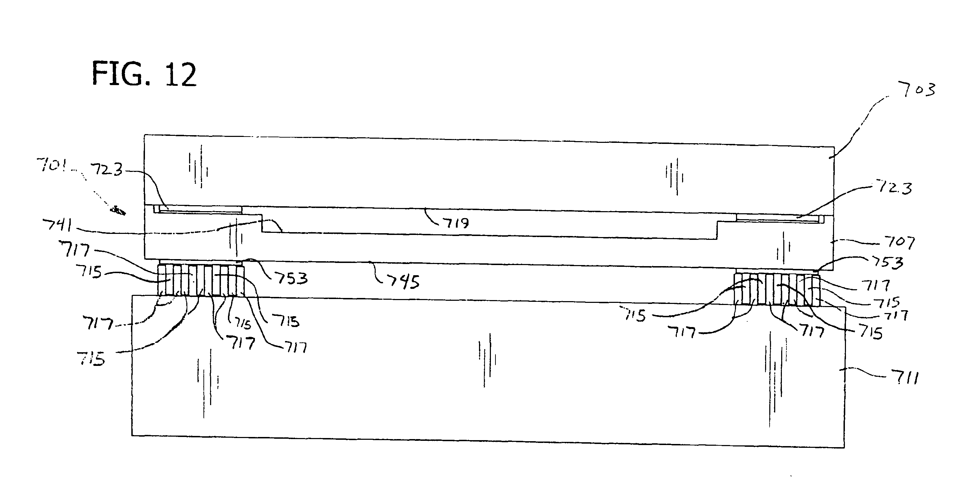

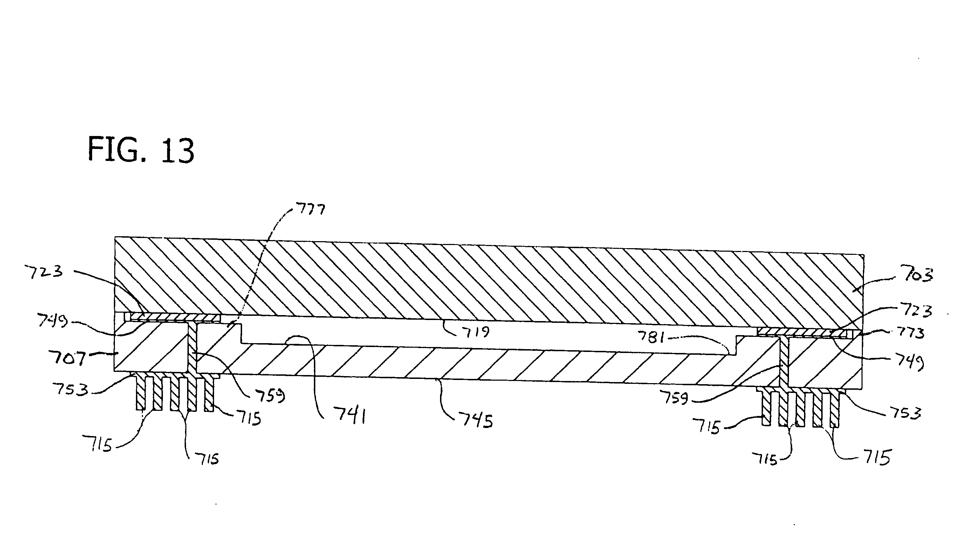

Referring now to Figs. 12 and 13, a integrated circuit device package, generally designated 701, comprises an integrated circuit device 703 mounted on a interconnect substrate 707. As shown in Fig. 12, the package 701 is electrically and mechanically connected to an electronic circuit substrate 711 (e.g., printed circuit board, ball-grid array, or land-grid array) by electrical conductive connecting elements 715 on the interconnect substrate 707. In one embodiment, the electrically conductive connecting elements 715 are placed into electrical contact with electrically conductive connecting elements 717 on the electronic circuit substrate 711 so that electrical signals can be passed to the integrated circuit device package 701. The integrated circuit device 703 is shown schematically but it will be understood that the circuit device could comprise any typical circuit device having an active side 719 requiring a protected, enclosed space (e.g., a MEMS device or an OE device). The integrated circuit device 703 has electrical connection pads 723 spaced in from the periphery of the circuit device and constructed similar to the pads 23 described above for the integrated circuit device 3 shown in Figs. 1 and 2. The connection pads 723 on the circuit device 703 shown in Fig. 12 are located on the active side 719 of the chip which typically has moving parts (not shown) that are actuated by the electrical signals received from the electronic circuit substrate 711.

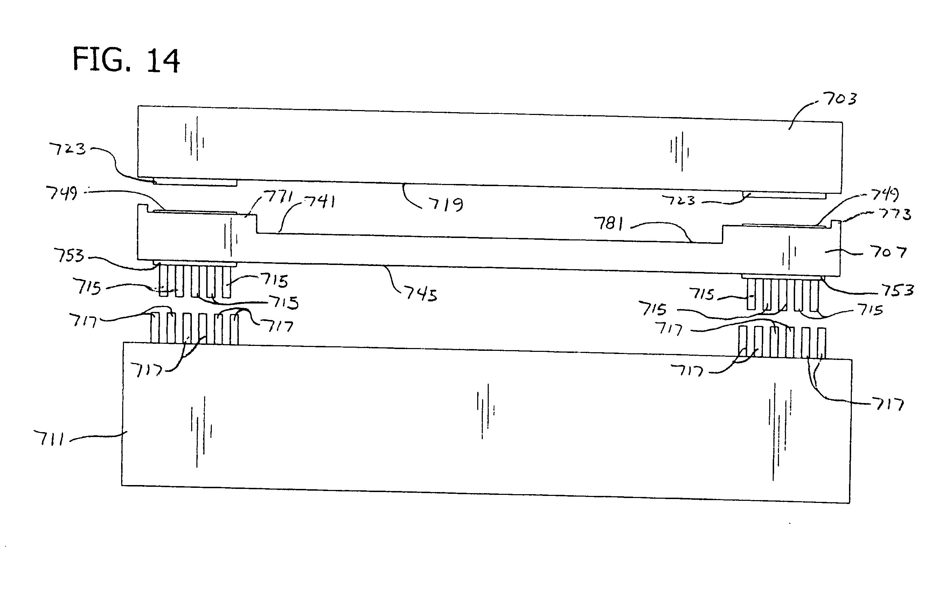

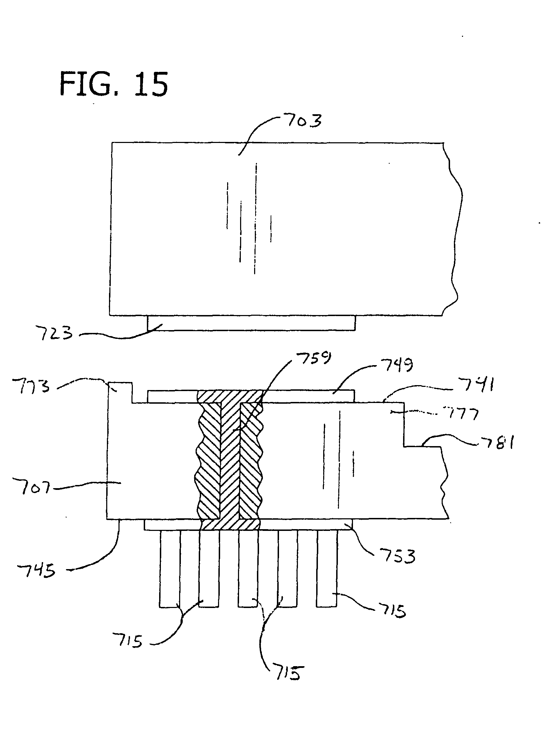

Typically, the interconnect substrate 707 is made using the same chip fabrication processes and the same semiconductor material (e.g., silicon) as the circuit device 703. Alternatively, the interconnect substrate could have a window (not shown) or could comprise translucent material to allow light to pass through the interconnect substrate and reach an optical MEMS device 703. The interconnect substrate 707 has a first side 741 adapted for contact with the active side 719 of the integrated circuit device 703 and a second side 745 adapted for electrical connection with the electronic circuit substrate 711. As best seen in Figs. 14 and 15, the interconnect substrate 707 has multiple sets of electrical connection pads, each set comprising a first pad 749 on the first side of the substrate and a second pad 753 on the second side of the substrate. Each electrical connection pad 749, 753 is preferably located near the periphery of the interconnect substrate 707. As best seen in Fig. 13, the connections pads 749, 753 of the interconnect substrate 707 are electrically connected by a metallized via 759 passing though the interconnect substrate. The connection pads 749 on the interconnect substrate 707 are arranged to contact a corresponding pad 723 on the active side 719 of the integrated circuit device 703, and the pads 753 on the second side 745 of the interconnect substrate are adapted for connection with the electrical connection pads 717 of electronic circuit substrate 711.

In one embodiment, the electrically conductive connecting elements 715 on the interconnect substrate 707 comprise electrically conductive connecting projections similar to the connecting elements 37 described above for the integrated circuit device 3 of Fig. 1. Each projection 715 may be a metallized projection formed integral with the electrical connection pad 753 or may be a metal projection bonded to the connection pad by a conventional manufacturing process. As seen in Figs. 12 and 14, the spaced apart electrically conductive connecting elements 717 comprise projections similar to the connecting elements 39 described above for the earlier embodiments. The projections 715 on the interconnect substrate 707 and the projections 717 on the electronic circuit substrate 711 are adapted for interdigitation to form an electrical and mechanical connection between the chip-scale package 701 and the electronic circuit substrate. It will be understood that the projections 715 on the interconnect substrate 707 and the projections 717 on the electronic circuit substrate 711 can comprise any of the embodiments of the electrically conductive connecting elements discussed above or any other connecting elements commonly used to connect an integrated circuit device to an electronic circuit substrate.

As best seen in Figs. 14 and 15, the first side 741 of the interconnect substrate 707 has an outer rim 773 along the peripheral edge of the interconnect substrate for sealing contact with the active side 719 of the circuit device 703. It will be understood that the interconnect substrate 707 and the integrated circuit device 703 may be bonded by any conventional wafer bonding method commonly used in the semiconductor industry (e.g., adhesive bonding, fusion bonding, or anodic bonding). The first side 741 of the interconnect substrate 707 has a shoulder 777 adjacent the outer rim 773 that supports each electrical connection pad 749 that mates with the corresponding electrical connection pad 723 of the integrated circuit device 703. In the embodiment of Fig. 15, each electrical connection pad 749 on the first side 741 of the interconnect substrate 707 has a planar contact surface for mating with a planar contact surface of a respective electrical connection pad 723 on the integrated circuit device 703. The interconnect substrate 707 has a recess 781 adjacent the shoulder 777 that forms the enclosed space of the package when the outer rim 773 is in contact with the active side 719 of the integrated circuit device 703. In the illustrated embodiment, the recess 781 is located on the interconnect substrate 707 and comprises approximately 60% to 75% of the surface area of the interconnect substrate. It will be understood that there could be more than one recess 781 of varying sizes on the interconnect substrate 707. Also, the integrated circuit 703 device could be configured to have an active side 719 that comprises a recess similar to the recess 781 so that the first side 791 of the interconnect substrate 707 is substantially planar.

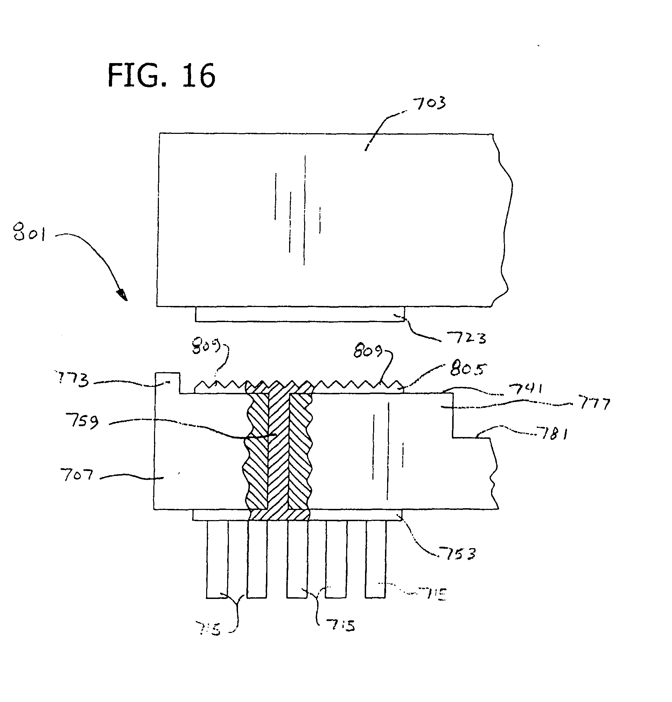

Fig. 16 shows a second embodiment of the integrated circuit device package, generally indicated 801. This embodiment 801 is substantially similar to the first embodiment of the package 701 except the electrical connection pads 805 on the first surface 741 of the interconnect substrate 707 comprise pointed projections or teeth 809 that contact the electrical connection pads 723 on the integrated circuit device 703. When the circuit device 703 is bonded to the interconnect substrate 707, the pointed projections 809 embed into the electrical connection pads 723 on the integrated circuit device to provide an additional mechanical force holding the integrated circuit device in electrical connection with the interconnect substrate 707. It will be understood that the projections 809 may have different sizes and shapes (e.g. cylindrical projections with blunt ends) without departing from the scope of this invention.

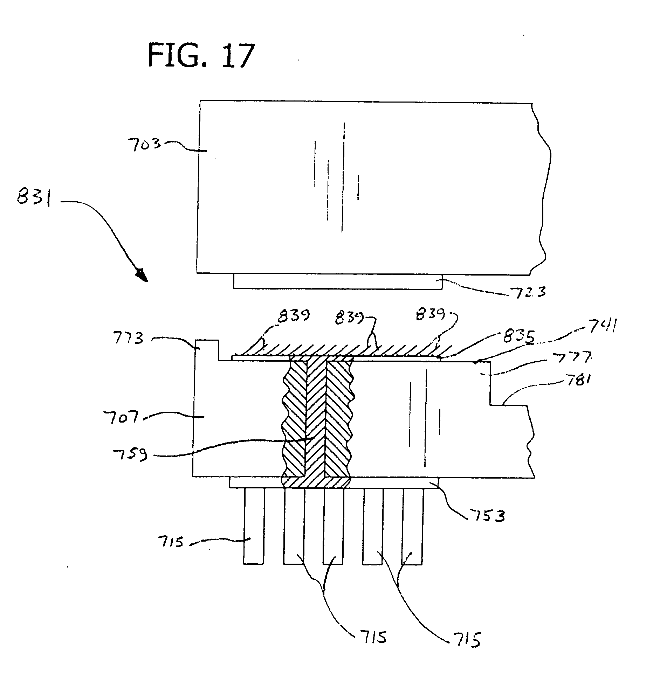

Fig. 17 shows a third embodiment of the integrated circuit device package, generally indicated 831. This embodiment 831 is substantially similar to the first embodiment of the package 701 except that the electrical connection pads 835 on the first side 741 of the interconnect substrate 707 comprise one or more electrically conductive springs 839 that extend from the connection pads. The springs 839 allow for electrical conduction between the integrated circuit device 703 and the interconnect substrate 707 when the circuit device is slightly misaligned so that the planar surface of the electrical connection pads 835 on the interconnect substrate 707 are slightly out of parallel with the planar surface of the electrical connection pads 723 on the circuit device. Preferably, the springs 839 are made integral with connection pads 835 from conventional spring metal materials (e.g., Molybdenum and Chromium) by using conventional fabrication techniques. Reference may be made to U.S. Patent Nos. 6,560,851 and 5,613,861, incorporated by reference herein for all purposes, for conventional microspring materials and fabrication processes.

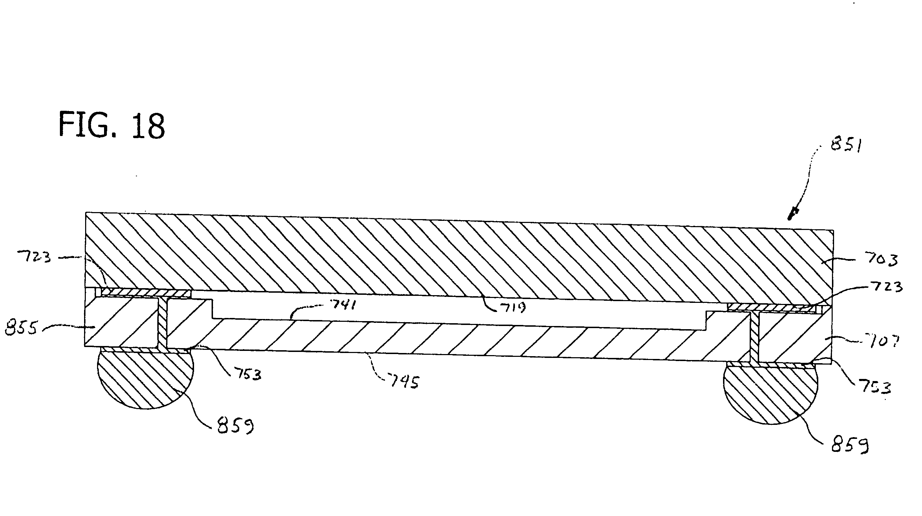

Fig. 18 illustrates a fourth embodiment of the integrated circuit device package, generally designated 851 . This embodiment 851 is substantially similar to the first embodiment of the package 701 but includes an interconnect substrate 855 with electrically conductive connecting elements that comprise solder balls 859 rather than electrically conductive projections 715 (Fig. 12). The package 851 may be mounted by conventional means directly on electrically conductive connection pads (not shown) of the electronic circuit substrate 711 by placing the package 851 on the substrate and heating the package to reflow the solder balls 859. Alternatively, the electrically conductive connecting elements 859 of this embodiment could also comprise other materials such as conductive adhesives that can be used to electrically and mechanically attach the integrated circuit device package 851 to the electronic circuit substrate 711.

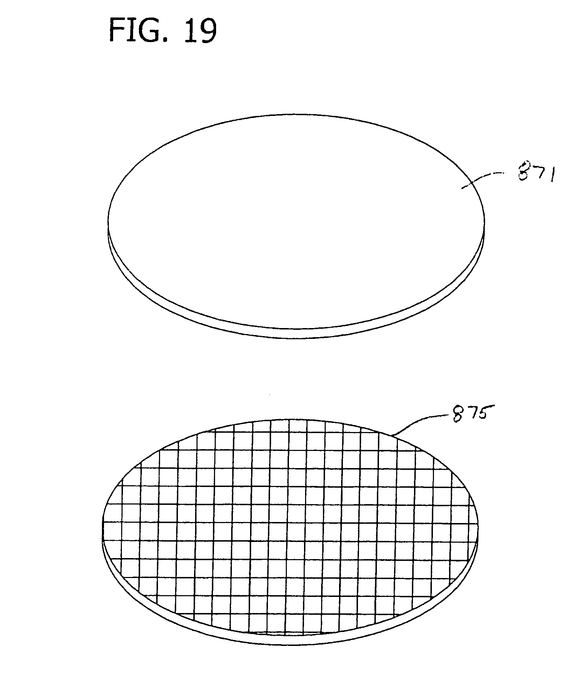

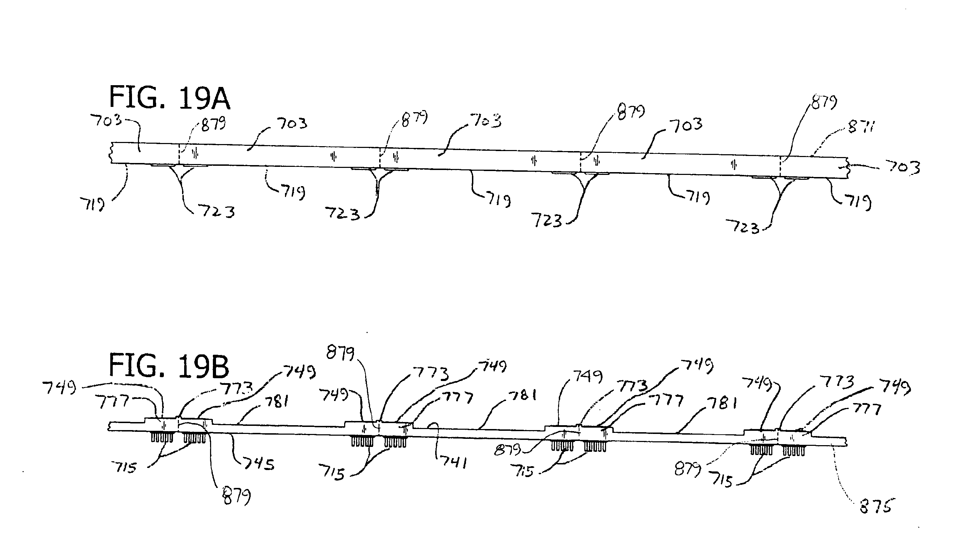

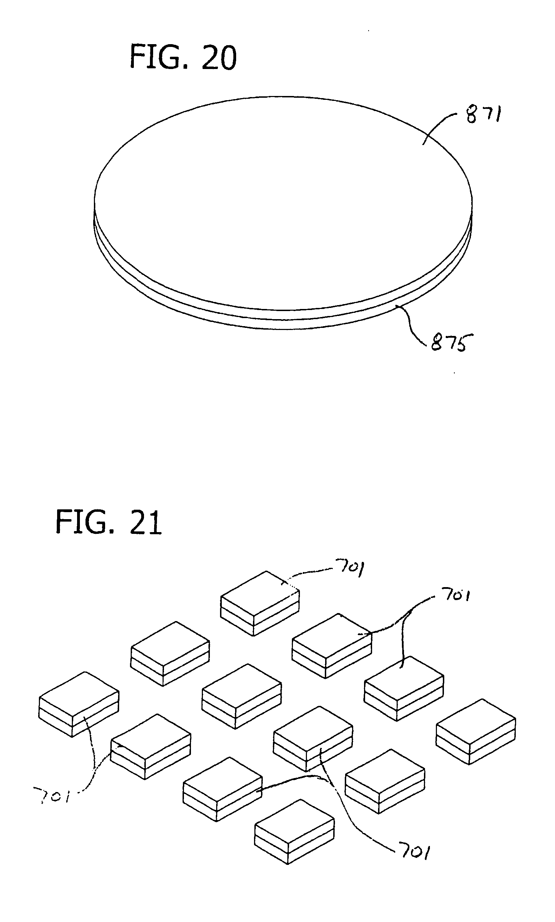

Referring to Figs. 19-21, the integrated circuit device package 701 shown in Figs. 12-18 can be formed by a wafer level fabrication process that results in a plurality of individual integrated circuit device packages. The process comprises fabricating an integrated circuit device wafer 871 having a plurality of integrated circuit devices 703 that each have an active side 719 and a plurality of electrical connection pads 723 on the active side. As shown in Fig. 19B, an interconnect substrate wafer 875 is fabricated to have a plurality of surfaces corresponding with the outer rim 773, shoulder 777 and recess 781 described above for each individual integrated circuit device package 701. The interconnect substrate wafer 875 has a plurality of electrical connection pads 749 fabricated on the shoulders 777 of the first side 741 of the substrate and a plurality of electrically conductive connecting elements 715 fabricated on the second side 745 of the wafer. It will be understood that the electrically conductive connecting elements may 715 be formed from any of the methods set forth above for electrically conductive connecting elements 37 on the integrated circuit device 3. Also, the wafers 871, 875 are fabricated from conventional wafer fabrication methods. Reference may be made to U.S. Patent Nos. 6,475,881; 6,159,826; 5,981,361; and 5,685,885, incorporated by reference herein for all purposes, for details of conventional wafer fabrication processes. As shown in Fig. 20, the circuit device wafer 871 and the interconnect substrate wafer 875 are bonded together by conventional bonding methods such that the outer rims 773 projecting from the first side 741 of the interconnect substrate wafer 875 are placed in sealing contact with the active side 719 of the integrated circuit device wafer 871. Also, the wafers 871, 875 are aligned prior to bonding such that their respective electrical connection pads 723, 749 are pressed together to form an electrical connection between the integrated circuit device wafer and the interconnect substrate wafer. After bonding, the joined wafers 871, 875 are diced by conventional dicing methods (e.g., laser cutting or sawing). In one embodiment, the wafers 871, 875 are cut along cut lines 879 which pass through rim formations on the interconnect substrate wafer corresponding to the outer rim 773 of the wafer 875 in contact with the integrated circuit device wafer 871. Preferably, the cut lines 879 are through the centers of these rim formations. The diced wafers result in individual integrated circuit device packages 701 (Fig. 21) having electrical conductive connection elements 715 that are ready for direct electrical and mechanical connection to an electronic circuit substrate 711 without requiring additional processing.

The package 701 of the present invention is a chip scale package (CSP) that approximates the size of the integrated circuit device 703 and requires only a very small amount of additional circuit board mounting area when compared to the bare chip mounted to the board by direct chip attachment. It will be understood that the package 701 will occupy a board mounting area larger than the bare integrated circuit device 703 by an amount approximately equal to the width of the outer rim 773 of the interconnect substrate 707. Preferably, the package 701 may have a board mounting area of approximately 1-20% larger than the mounting area of the bare integrated circuit device 703; more preferably the board mounting area of the package may be approximately 1-10% larger than the board mounting area of the bare integrated circuit device; and most preferably the board mounting area of the package may be approximately 1% larger than the board mounting area of the bare integrated circuit device.

In view of the above, it will be seen that the several objects of the invention are achieved and other advantageous results attained. The friction fit between the first projections 37 and second projections 39 of the chip module 1 allow for assembly and attachment of the integrated circuit device 3 to the substrate 13 without the application of heat and the resulting thermal stresses. The first projections 37 and second projections 39 on the circuit device 3 and substrate 13 are configured for interdigitation to allow the device to be easily removed from the substrate after testing and reconnected to the substrate without extensive rework. Also, the friction fit between the first and second projections 37, 39 allows easy repair and replacement of an integrated circuit device 3 in a final assembly. The first and second projections 37, 39 can be easily manufactured during the chip or substrate manufacturing process or the projections can be fabricated as an additional step after the chip or substrate fabrication process is complete. The integrated circuit device package 701 can be manufactured from a simple wafer level process that does not require additional processing for electrical connections from the package to the circuit board 711. The integrated circuit device package 701 provides an enclosed space to protect the integrated circuit device 703 and minimizes circuit board mounting area. The electrically conductive connecting elements 715, 859 on the integrated circuit device package 701, 851 allow the package to be easily mounted and removed from the electronic substrate 711.

As various changes could be made in the above constructions without departing from the scope of the invention, it is intended that all matter contained in the above description or shown in the accompanying drawings shall be interpreted as illustrative and not in a limiting sense. For example, the first and second projections 37, 39 could have alternative shapes and sizes that allow a friction fit holding the integrated circuit device 3 in electrical and mechanical contact with the substrate 13. Also, the first and/or second projections 37, 39 could be formed integral with a respective electrical connection pad 23, 27 or could be configured as an integral part of the integrated circuit device 3 or the substrate 13. Furthermore, the first and/or second projections 37, 39 could be finger-like projections that have a common base attached to, or formed integral with a respective electrical connection pad 23, 27.

When introducing elements of the present invention or the preferred embodiment(s) thereof, the articles "a", "an", "the" and "said" are intended to mean that there are one or more of the elements. The terms "comprising", "including" and "having" are intended to be inclusive and mean that there may be additional elements other than the listed elements.

## Claims

1. An assembly comprising:
a substrate,
an integrated circuit device adapted to be electrically and mechanically connected to the substrate,
electrical connection pads on the integrated circuit device and on the substrate adapted to contact one another when the circuit device and the substrate are connected,
said connection pads comprising at least one first projection on one of the device and the substrate and at least two second projections on the other of the device and the substrate, each projection having a respective axial length extending from an external surface of a respective connection pad,
the at least one first projection and at least two second projections having respective external surfaces that are sized and shaped for a close friction fit along their axial lengths when interdigitated relative to one another thereby to create an axial contact area between respective projections to establish an electrical and mechanical connection between the device and the substrate.

2. An assembly as set forth in claim 1 wherein said at least one first projection is on the integrated circuit device and said at least two second projections are on the substrate.

3. An assembly as set forth in claim 1 wherein said at least one first projection comprises a headless projection.

4. An assembly as set forth in claim 1 wherein said at least one first projection comprises a solid cylindrical body formed integral with said one of the circuit device or substrate and comprising a metal external surface for contacting said at least two second projections.

5. An assembly as set forth in claim 4 wherein said at least two second projections comprise solid cylindrical bodies and are spaced apart to form an open space for receiving said at least one first projection.

6. An assembly as set forth in claim 5 wherein said at least one first projection is adapted for insertion into said open space such that the device and substrate are held in electrical and mechanical connection by a friction fit between respective axial lengths of the at least one first projection and the at least two second projection.

7. An assembly as set forth in claim 1 wherein said at least one first projection comprises a frustum-shaped body.

8. An assembly as set forth in claim 1 wherein said at least one first projection and said at least two second projections have elliptical cross-sections.

9. An assembly as set forth in claim 1 wherein said at least one first projection and said plurality of second projections have polygonal cross-sections.

10. A integrated circuit device package comprising:
an integrated circuit device having an active side with at least one electrical connection pad thereon;
an interconnect substrate for mounting said integrated circuit device on an electronic circuit substrate, said interconnect substrate having a first side adapted to mate with the active side of the integrated circuit device to form an enclosed space and a second side adapted for electrical and mechanical connection to the electronic circuit substrate,
the interconnect substrate having at least one set of electrical connection pads, each set comprising a first electrical connection pad on the first side of the interconnect substrate adapted for electrical connection to the at least one electrical connection pad on the integrated circuit device and a second electrical connection pad on the second side of the interconnect substrate electrically connected to the first connection pad, said second electrical connection pad on the second side of the interconnect substrate being adapted for electrical and mechanical connection to the electronic circuit substrate.

11. A package as set forth in claim 10 wherein said second electrical connection pad comprises a solder ball for electrical and mechanical connection to the electronic circuit substrate.

12. A package as set forth in claim 10 wherein said second electrical connection pad comprises a projection having a substantially rigid cylindrical body extending from an external surface of the second electrical connection pad.

13. A package as set forth in claim 10 wherein said second electrical connection pad comprises at least one electrical conductive connecting element on the interconnect substrate and further comprising at least two electrical conductive connecting elements on the electronic circuit substrate adapted to mate with said at least one electrical conductive connecting element on the interconnect substrate, the electrical conductive connecting elements on the electronic circuit substrate and on the interconnect substrate being sized and shaped for a close interdigitated friction fit relative to one another thereby to establish an electrical and mechanical connection between the package and the electronic circuit substrate.

14. A package as set forth in claim 10 wherein said first electrical connection pad on the interconnect substrate comprises at least one protrusion adapted for contact with said integrated circuit device electrical connection pad.

15. A package as set forth in claim 10 wherein said first electrical connection pad on the interconnect substrate comprises at least one spring adapted to contact the integrated circuit device electrical connection pad.

16. A package as set forth in claim 10 wherein said first side of said interconnect substrate comprises an outer rim for sealing contact with said integrated circuit device and a recess that forms said enclosed space upon contact of said outer rim with said integrated circuit device.

17. A package as set forth in claim 16 wherein said first side of said interconnect substrate further comprises a shoulder between the recess and the outer rim for placement of the first electrical connection pad of the interconnect substrate.

18. A process for forming an integrated circuit device package, the process comprising the steps of:
fabricating an integrated circuit device wafer having an active side;
fabricating an interconnect substrate wafer such that said wafer has electrical connection pads on opposite sides thereof and a recessed surface;
electrically and mechanically connecting the integrated circuit device wafer and interconnect substrate wafer such that the two wafers form an enclosed space between the active side of said integrated circuit device wafer and the recessed surface of the interconnect substrate wafer; and
dicing the integrated circuit device wafer and interconnect substrate wafer to form one or more individual integrated circuit device packages.

19. The process as set forth in claim 18 wherein said fabricating an interconnect substrate wafer step includes configuring the interconnect substrate wafer to have at least one electrical conductive connecting element for electrical and mechanical connection to an electronic circuit substrate.

20. The process as set forth in claim 18 wherein said dicing step comprises cutting the joined wafers into said one or more individual integrated circuit device packages.

21. An interconnect substrate for mounting an integrated circuit device on an electronic circuit substrate, said interconnect substrate comprising:
a first side adapted to mate with an active side of the integrated circuit device to form an enclosed space and a second side adapted for electrical and mechanical connection to the electronic substrate,
a first electrical connection pad on the first side of the interconnect substrate adapted for electrical connection to the integrated circuit device, and
a second electrical connection pad on the second side of the interconnect substrate electrically connected to the first connection pad, said second electrical connection pad on the second side of the interconnect substrate being adapted for electrical and mechanical connection to the electronic circuit substrate.

22. An interconnect substrate as set forth in claim 21 wherein said first side of said interconnect substrate comprises an outer rim for sealing contact with said integrated circuit device.

23. An interconnect substrate as set forth in claim 22 wherein said first side of said interconnect substrate further comprises a recess that forms said enclosed space upon contact of said outer rim with said integrated circuit device.

24. An interconnect substrate as set forth in claim 22 wherein said first side of said interconnect substrate further comprises a shoulder between the recess and the outer rim for placement of the first electrical connection pad.

25. An interconnect substrate as set forth in claim 22 wherein said first electrical connection pad comprises at least one protrusion adapted for contact with an electrical connection pad on the integrated circuit device.

26. An interconnect substrate as set forth in claim 22 wherein said first electrical connection pad comprises at least one spring adapted for contact with an electrical connection pad on the integrated circuit device.
